# EUROPEAN PATENT APPLICATION

(11) **EP 3 800 752 A1**
(43) Date of publication of application: **07.04.2021**
(21) Application number: 18930400.9
(22) Date of filing: 11.12.2018
(51) Int. Cl.: H02G 3/22

(54) **WIRE PASSAGE STRUCTURE, ELECTRIC BOX AND AIR CONDITIONER**

(30) Priority: 13.08.2018 CN 201810918084
(71) Applicant: Gree Electric Appliances, Inc. of Zhuhai, Zhuhai, Guangdong 519070 (CN)
(72) Inventor: HUANG, Haiqiang, Zhuhai City, Guangdong 519070 (CN); LI, Mengzhi, Zhuhai City, Guangdong 519070 (CN); YAO, Xinxiang, Zhuhai City, Guangdong 519070 (CN); YAO, Gang, Zhuhai City, Guangdong 519070 (CN); LIANG, Yaoxiang, Zhuhai City, Guangdong 519070 (CN); ZHU, Haishuang, Zhuhai City, Guangdong 519070 (CN); LUO, Yanzan, Zhuhai City, Guangdong 519070 (CN); HUANG, Zhihua, Zhuhai City, Guangdong 519070 (CN); LIN, Qianglian, Zhuhai City, Guangdong 519070 (CN); HUANG, Foyi, Zhuhai City, Guangdong 519070 (CN)
(74) Representative: Berggren Oy, Tampere
(86) International application number: PCT/CN2018/120387
(87) International publication number: WO 2020/034505

(57) **Abstract**

Some embodiments of the present invention provide a wire layout structure, an electric box and an air conditioner, the wire layout structure includes a body portion (10), the body portion (10) is provided with an accommodation hole (11) for accommodating wire bodies (20); and at least a part of the body portion (10) is configured to be rotatable, such that the accommodation hole (11) has a first state of releasing the wire bodies (20) and a second state of clamping the wire bodies (20). The wire layout structure solves a problem of low efficiency of installing wire bodies (20) in an art known to inventors.

## Description

### Technical Field

The invention relates to a field of wire layout structures, and in particular to a wire layout structure, an electric box and an air conditioner.

### Background

In a machine that uses a flammable refrigerant, a problem of sparking easily happens to an element inside an electric box, if a leakage hidden trouble exists in the flammable refrigerant, a safety accident occurs.

In order to prevent the leakage hidden trouble existing in the flammable refrigerant, an wire layout structure known to inventors is capable of, through enabling wire bodies to be wrapped in an accommodating cavity, and then enabling the wire layout structure to be sealed in the electric box, preventing the flammable refrigerant from entering an interior of the electric box through gaps between wire bodies or between the wire layout structure and the electric box. However, it is considered that this type of the wire layout structure is a sealed structure and it is extremely inconvenient to place wire bodies, installation efficiency is seriously affected.

### Summary

Some embodiments of the invention provide a wire layout structure, an electric box and an air conditioner, to solve a problem of low efficiency of installing wire bodies in an art known to inventors.

Some embodiments of the invention provide a wire layout structure, the wire layout structure includes: a body portion, the body portion is provided with an accommodation hole for accommodating wire bodies; wherein, at least a part of the body portion is rotatably disposed, such that the accommodation hole has a first state of releasing the wire bodies and a second state of clamping the wire bodies.

In some embodiments, the body portion includes: a first body section; and a second body section, a first end of the first body section is fixedly connected with a first end of the second body section, and a second end of the first body section is detachably connected with a second end of the second body section; wherein, at least one of the first body section and the second body section is provided with the accommodation hole, the first body section is rotatably disposed relative to the second body section, such that the accommodation hole has the first state and the second state.

In some embodiments, the first body section is provided with a first accommodating groove, and the second body section is provided with a second accommodating groove, when the second end of the first body section is connected with the second end of the second body section, the first accommodating groove is connected with the second accommodating groove in an opposite manner so as to form the accommodation hole.

In some embodiments, the second end of the first body section is connected with the second end of the second body section in a clamping manner.

In some embodiments, the first body section is provided with a first clamping portion, the second body section is provided with a second clamping portion, and the first clamping portion is connected with the second clamping portion in a clamping manner.

In some embodiments, the first clamping portion is a protrusion, the second clamping portion is a groove, and the first clamping portion is in interference fit with the second clamping portion; or the first clamping portion is the groove, the second clamping portion is the protrusion, and the first clamping portion is in interference fit with the second clamping portion.

In some embodiments, the body portion further includes: a connection section, the connection section is disposed between the first end of the first body section and the first end of the second body section, the connection section is configured to connect the first body section and the second body section; wherein, the first body section is rotatably disposed by taking the connection section as a rotation shaft, and/or the second body section is rotatably disposed by taking the connection section as a rotation shaft.

In some embodiments, the connection section is a flexible structure.

In some embodiments, the first body section, the second body section and the connection section are integrally formed.

In some embodiments, a hole wall of the accommodation hole is provided with a sealing portion, the accommodation hole is configured for accommodating at least two wire bodies, and the sealing portion is disposed between two adjacent wire bodies.

In some embodiments, there are plurality of sealing portions, the plurality of sealing portions are disposed along a circumferential direction of the hole wall of the accommodation hole in a spacing manner.

In some embodiments, there are a plurality of rows of the sealing portions, the plurality of rows of the sealing portions are disposed along an axis direction of the accommodation hole in a spacing manner, wherein, each row of the sealing portions includes a plurality of a plurality of sub sealing portions, and the plurality of sub sealing portions are disposed along a circumferential direction of the hole wall of the accommodation hole in a spacing manner.

In some embodiments, the body portion is made of a flexible material, such that a size of the accommodation hole is adjustably disposed.

In some embodiments, the hole wall of the accommodation hole is provided with a first recess portion, the first recess portion is extended along a circumferential direction of the accommodation hole.

In some embodiments, there are a plurality of first recess portions, and the plurality of first recess portions are disposed along an axis direction of the accommodation hole in a spacing manner.

In some embodiments, a convex portion is formed between two adjacent first recess portions, the convex portion is provided with a sealing portion, the accommodation hole is configured for accommodating at least two wire bodies, and the sealing portion is disposed between the two adjacent wire bodies.

In some embodiments, an outer surface of the body portion is provided with a second recess portion, the second recess portion is extended along a circumferential direction of the body portion, wherein, the second recess portion and the first recess portion are disposed in a staggered manner.

In some embodiments, there are a plurality of second recess portions, and the plurality of second recess portions are disposed along an axial direction of the body portion in a spacing manner.

Some embodiments of the present invention provided an electric box, the electric box includes the above wire layout structure and an electric box body portion, and the wire layout structure is disposed on the electric box body portion.

In some embodiments, the electric box body portion is provided with an installing hole, at least a part of the body portion of the wire layout structure is disposed in the installing hole, wherein, the body portion is in interference fit with the installing hole.

In some embodiments, the electric box body portion includes: a base, wherein the base is provided with a first installing hole section; and a top cover, wherein the top cover is provided with a second installing hole section, the top cover is connected with the base, the first installing hole section is connected with the second installing hole section in an opposite manner, so as to form the installing hole, at least a part of the body portion is clamped between the top cover and the base in a clamping manner.

In some embodiments, the first installing hole section is provided with a first installing groove, the body portion is provided with a first sealing protrusion, at least a part of the first sealing protrusion is disposed in the first installing groove.

In some embodiments, the second installing hole section is provided with a second installing groove, the first installing groove is disposed opposite to the second installing groove, the first sealing protrusion is extended along a circumferential direction of the body portion, the first sealing protrusion is disposed between the first installing groove and the second installing groove; and wherein, an outer surface of the first sealing protrusion is in interference fit with at least a part of a groove bottom of the first installing groove, and/or in interference fit with at least a part of a groove bottom of the second installing groove.

In some embodiments, there are a plurality of first sealing protrusions, the plurality of first sealing protrusions are disposed along an axial direction of the body portion in a spacing manner, there are a plurality of first installing grooves and a plurality of second installing grooves, and the plurality of first installing grooves and the plurality of second installing grooves are disposed corresponding to the plurality of first sealing protrusions in one-to-one correspondence.

In some embodiments, a projection, along the axial direction of the body portion, of the first sealing protrusion is a polygon, wherein, at least two adjacent first sealing protrusions are disposed in a staggered manner, an outer circumferential surface of the first sealing protrusion is provided with a first faying surface, a circumferential outer surface of the second first sealing protrusion is provided with a second faying surface, a preset included angle a is formed between the first faying surface and the second faying surface, and the a is an acute angle.

In some embodiments, a projection, along the axial direction of the body portion, of the first sealing bulge is the polygon, a partial outer surface of the first sealing protrusion is in interference fit with the groove bottom of the first installing groove, and/or the groove bottom of the second installing groove.

In some embodiments, outer surfaces of the plurality of first sealing protrusions are in crossed interference fit with the groove bottoms of the plurality of first installing grooves, and/or in crossed interference fit with the groove bottoms of the plurality of second installing grooves.

Some embodiments of the present invention provide an air conditioner, and the air conditioner includes the above electric box.

In the wire layout structure of some embodiments in the present invention, at least a part of the body portion is rotatably disposed, such that the accommodation hole has the first state of releasing the wire bodies and the second state of clamping the wire bodies, thereby improving installation efficiency of the wire bodies. Wherein, the body portion is provided with the accommodation hole for accommodating the wire bodies. In a specific installing process, at least a part of the body portion is rotated, such that the accommodation hole is located in the first state, thereby the wire bodies are placed in the accommodation hole, and then at least a part of the body portion is rotated, such that the accommodation hole is located in the second state, thus it is guaranteed that the wire bodies are clamped by the body portion. In the wire layout structure of some embodiments in the present invention, at least a part of the body portion is rotatably disposed, such that the accommodation hole has the first state of releasing the wire bodies and the second state of clamping the wire bodies, thereby improving the installation efficiency of the wire bodies, and solving the problem of low efficiency of installing the wire bodies in the wire layout structure in the art known to inventors.

### Brief Description of the Drawings

The accompanying drawings, which constitute a part of the present invention, are configured to provide a further understanding of the invention, and the exemplary embodiments of the invention and the description thereof are configured to explain the invention, but do not constitute improper limitations to the invention. In the drawings:
Fig. 1 illustrates a wire-coordinated structure schematic diagram while a wire layout structure of some embodiments in the present invention is located in a second state;
Fig. 2 illustrates a wire-coordinated structure schematic diagram while the wire layout structure of some embodiments in the present invention is located in a first state;
Fig. 3 illustrates a structure schematic diagram while the wire layout structure of some embodiments in the present invention is located in the second state;
Fig. 4 illustrates a structure schematic diagram while the wire layout structure of some embodiments in the present invention is located in the first state;
Fig. 5 illustrates a front view of the wire layout structure of some embodiments in the present invention;
Fig. 6 illustrates a side view of the wire layout structure of some embodiments in the present invention;
Fig. 7 illustrates an exploded structure schematic diagram of an electric box of some embodiments in the present invention;
Fig. 8 illustrates a structure schematic diagram of a base of the electric box of some embodiments in the present invention;
Fig. 9 illustrates a structure schematic diagram of a top cover of the electric box of some embodiments in the present invention; and
Fig. 10 illustrates a sectional structure schematic diagram of the electric box of some embodiments in the present invention.

Herein, the above drawings include the following drawing reference signs:
10. body portion; 11. accommodation hole; 111. sealing portion; 112. first recess portion; 12. first body section; 121. first accommodating groove; 122. first clamping portion; 13. second body section; 131. second accommodating groove; 132. second clamping portion; 14. connection section; 15. second recess portion; 16. first sealing protrusion; 161. first faying surface; 162. second faying surface; 20. wire; 30. electric box body portion; 31. installing hole; 32. base; 321. first installing hole section; 3211. first installing groove; 33. top cover; 331. second installing hole section; and 3311. second installing groove.

### Detailed Description of the Embodiments

It should be noted that the embodiments in the present invention and the features in the embodiments are combined with each other without conflict. The invention will be described in detail below with reference to the accompanying drawings and in conjunction with the embodiments.

It should be pointed out that the following detailed descriptions are illustrative and are intended to provide further explanation of the present invention. Unless defined otherwise, all technical and scientific terms configured herein have the same meaning as commonly understood by a person of ordinary skill in the art to which the present invention belongs.

It should be noted that terms configured here are only configured for describing specific implementation modes, and are not intended to limit the exemplary implementation modes according to the present invention. As configured herein, unless clearly specified otherwise in the context, a singular form is also intended to include a plural form. In addition, it should also be understood that when the terms "comprising" and/or "including" are configured in the description, it is indicated that there are features, steps, operations, devices, components and/or combinations thereof.

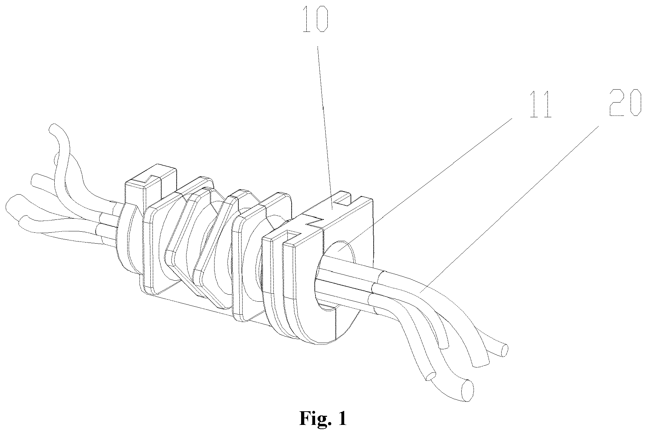

Some embodiments of the present invention provides a wire layout structure, reference to Fig. 1 to Fig. 6, the wire layout structure includes: a body portion 10, the body portion 10 is provided with an accommodation hole 11 for accommodating wire bodies 20; and wherein, at least a part of the body portion 10 is rotatably disposed, such that the accommodation hole 11 has a first state of releasing the wire bodies 20 and a second state of clamping the wire bodies 20.

The wire layout structure of some embodiments in the present invention is capable of, through rotatably disposing at least a part of the body portion 10, such that the accommodation hole 11 has the first state of releasing the wire bodies 20 and the second state of clamping the wire bodies 20, thereby improving installation efficiency of the wire bodies 20. wherein, the body portion 10 is provided with the accommodation hole 11 for accommodating the wire bodies 20. In a specific installing process, at least a part of the body portion 10 is rotated, such that the accommodation hole 11 is located in the first state, thereby the wire bodies 20 are placed in the accommodation hole 11, and then at least a part of the body portion 10 is rotated, such that the accommodation hole 11 is located in the second state, thus it is guaranteed that the wire bodies 20 are clamped by the body portion 10. The wire layout structure of some embodiments in the present invention is capable of, through rotatably configuring at least a part of the body portion 10, such that the accommodation hole 11 has the first state of releasing the wire bodies 20 and the second state of clamping the wire bodies 20, thereby improving the installation efficiency of the wire bodies 20, and solving a problem of low efficiency of installing the wire bodies in the wire layout structure in the art known to inventors.

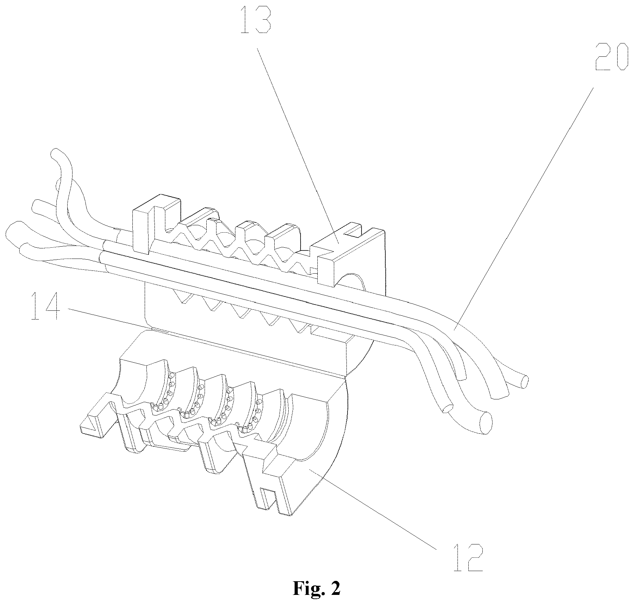

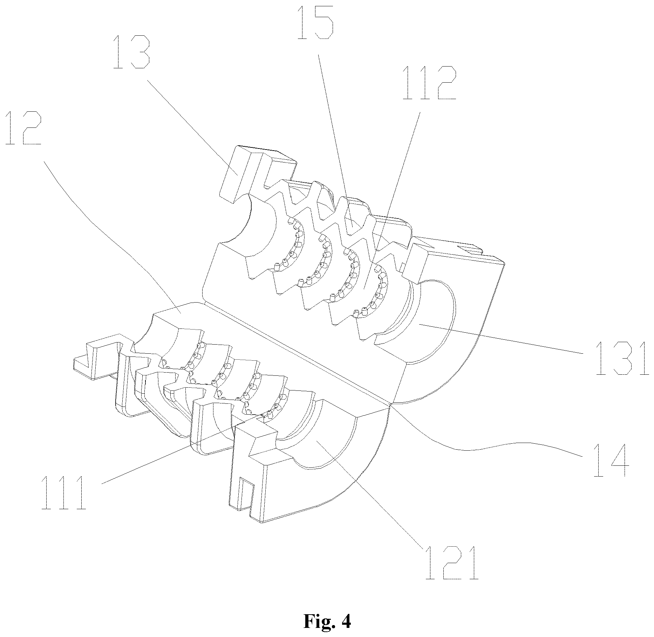

In allusion to a specific structure of the body portion 10, as shown in Fig. 2 and Fig. 4, the body portion 10 includes: a first body section 12; and a second body section 13, a first end of the first body section 12 is fixedly connected with a first end of the second body section 13, and a second end of the first body section 12 is detachably connected with a second end of the second body section 13; and wherein, at least one of the first body section 12 and the second body section 13 is provided with the accommodation hole 11, the first body section 12 is rotatably disposed relative to the second body section 13, such that the accommodation hole 11 has the first state and the second state.

In some embodiments, the body portion 10 is formed by the first body section 12 and the second body section 13, the first end of the first body section 12 is fixedly connected with the first end of the second body section 13, in order to enable the accommodation hole 11 to have the first state of releasing the wire bodies 20 and the second state of clamping the wire bodies, the second end of the first body section 12 is detachably connected with the second end of the second body section 13, thereby installing and clamping of the wire bodies 20 are conveniently achieved.

In some embodiments, at least one of the first body section 12 and the second body section 13 is provided with the accommodation hole 11, namely, the accommodation hole 11 is separately disposed on the first body section 12 or the second body section 13, or also is formed by splicing hole sections on the first body section 12 or the second body section 13. Through rotatably disposing the first body section 12 relative to the second body section 13, the accommodation hole 11 has the first state and the second state, thereby installing and clamping of the wire bodies 20 are achieved.

In some embodiments, at least one of the first body section 12 and the second body section 13 is provided with the accommodation hole 11, the first body section 12 is rotatably disposed around the first end of the second body section 13, and the second body section 13 is rotatably disposed around the first end of the first body section 12; or, the first body section 12 is rotatably disposed around the first end of the second body section 13; or, the second body section 13 is rotatably disposed around the first end of the first body section 12; such that the accommodation hole 11 has the first state and the second state.

In some embodiments, as shown in Fig. 4, the first body section 12 is provided with a first accommodating groove 121, and the second body section 13 is provided with a second accommodating groove 131, when the second end of the first body section 12 is connected with the second end of the second body section 13, the first accommodating groove 121 is connected with the second accommodating groove 131 in an opposite manner so as to form the accommodation hole 11.

In some embodiments, an openable-closeable overall structure is formed by the first body section 12 and the second body section 13, through disposing the first accommodating groove 121 on the first body section 12, and disposing the second accommodating groove 131 on the second body section 13, thereby when the first body section 12 and the second body section 13 are relatively opened, the first accommodating groove 121 is separated from the second accommodating groove 131, thus the installing of the wire bodies 20 is achieved, when the first body section 12 and the second body section 13 are relatively closed, the first accommodating groove 121 is connected with the second accommodating groove 131 in an opposite manner, thus the clamping of the wire bodies 20 is achieved.

In some embodiments, the second end of the first body section 12 is in connection with the second end of the second body section 13 in a clamping manner.

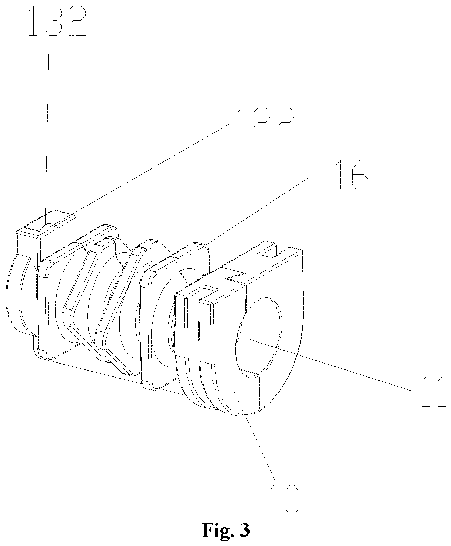

In some embodiments, as shown in Fig. 3, the first body section 12 is provided with a first clamping portion 122, the second body section 13 is provided with a second clamping portion 132, and the first clamping portion 122 is connected with the second clamping portion 132 in a clamping manner.

In allusion to specific structures of the first clamping portion 122 and the second clamping portion 132, the first clamping portion 122 is a protrusion, the second clamping portion 132 is a groove, and the first clamping portion 122 is in interference fit with the second clamping portion 132; or the first clamping portion 122 is the groove, the second clamping portion 132 is the protrusion, and the first clamping portion 122 is in interference fit with the second clamping portion 132.

In some embodiments, each of the first clamping portion 122 and the second clamping portion 132 is formed by two mutually separated partial sections of which a middle is connected by other structures.

In order to enable the first body section 12 to be rotatably disposed relative to the second body section 13, as shown in Fig. 2, the body portion 10 further includes: a connection section 14, the connection section 14 is disposed between the first end of the first body section 12 and the first end of the second body section 13, the connection section 14 is configured to connect the first body section 12 and the second body section 13; and wherein, the first body section 12 is rotatably disposed by taking the connection section 14 as a rotation shaft, and/or the second body section 13 is rotatably disposed by taking the connection section 14 as the rotation shaft.

In some embodiments, the body portion 10 is formed by the first body section 12, the second body section 13 and the connection section 14, the connection section 14 is configured to connect the first body section 12 and the second body section 13. In specific use, the first body section 12 is rotatably disposed by taking the connection section 14 as the rotation shaft, thus open or close of the body portion 10 is achieved. Or, the second body section 13 is rotatably disposed by taking the connection section 14 as the rotation shaft.

In some embodiments, the connection section 14 is a flexible structure.

Through enabling the connection section 14 to be disposed as the flexible structure, it is conveniently achieved that the first body section 12 is rotatably disposed by taking the connection section 14 as the rotation shaft, or the second body section 13 is rotatably disposed by taking the connection section 14 as the rotation shaft.

In order to machine conveniently, the first body section 12, the second body section 13 and the connection section 14 are integrally formed.

It is considered that a certain gap exists between the wire bodies 20 in the accommodation hole 11, thus a problem of poor sealability occurs, as shown in Fig. 4, a hole wall of the accommodation hole 11 is provided with a sealing portion 111, the accommodation hole 11 is configured for accommodating at least two wire bodies 20, and the sealing portion 111 is disposed between two adjacent wire bodies 20.

In some embodiments, at least two wire bodies 20 are disposed in the accommodation hole 11, namely at least two wire bodies 20 are accommodated in the accommodation hole 11, a certain gap occurs between the wire bodies 20, so the sealing portion 11 is filled between the two adjacent wire bodies 20, thus sealing between the wire bodies 20 is achieved.

In some embodiments, there are a plurality of sealing portions 111, the plurality of sealing portions 111 are disposed along a circumferential direction of the hole wall of the accommodation hole 11 in a spacing manner.

In some embodiments, there are a plurality of rows of the sealing portions 111, the plurality of rows of the sealing portions 111 are disposed along an axis direction of the accommodation hole 11 in a spacing manner, wherein, each row of the sealing portions 111 includes a plurality of sub sealing portions, and the plurality of sub sealing portions are disposed along the circumferential direction of the hole wall of the accommodation hole 11.

In some embodiments, a partial sealing section, disposed between the two adjacent wire bodies 20, of the sealing portion 111 is a cone-shaped section.

In some embodiments, at least a part of the sealing portion 111 is a cone-shaped section body.

In order to enable different numbers of the wire bodies 20 to be disposed in the accommodation hole 11, the body portion 10 is made of a flexible material, such that a size of the accommodation hole 11 is adjustably disposed.

In some embodiments, through enabling the body portion 10 to be made of the flexible material, namely the body portion 10 is deformed integrally, while there are many wire bodies 20, the body portion 10 is opened by the wire bodies 20, thus a placing number of the wire bodies 20 is satisfied.

In order to conveniently achieve flexible deformation of the body portion 10, as shown in Fig. 4, the hole wall of the accommodation hole 11 is provided with a first recess portion 112, the first recess portion 112 is extended along the circumferential direction of the accommodation hole 11.

In some embodiments, the hole wall of the accommodation hole 11 is provided with the first recess portion 112, the first recess portion 112 is extended along the circumferential direction of the accommodation hole 11, and a wall surface of the first recess portion 112 is an arc-shaped surface or a wave-shaped surface integrally. While there are many wire bodies 20, because of an existence of the first recess portion 112, the body portion 10 is conveniently deformed.

In some embodiments, there are a plurality of first recess portions 112, and the plurality of first recess portions 112 are disposed along an axis direction of the accommodation hole 11 in a spacing manner.

In allusion to a specific structure of the hole wall of the accommodation hole 11, as shown in Fig. 4, a convex portion is formed between the two adjacent first recess portions 112, the convex portion is provided with the sealing portion 111, the accommodation hole 11 is configured for accommodating at least two wire bodies 20, and the sealing portion 111 is disposed between the two adjacent wire bodies 20.

In some embodiments, there are a plurality of first recess portions 112, and the convex portion is formed between two adjacent first recess portions 112, through disposing the sealing portion 111 on the convex portion, the sealing portion 111 is filled between the two adjacent first recess portions 112, thus the sealing between the wire bodies 20 is achieved.

In order to further conveniently flexible-deform the body portion 10, as shown in Fig. 4, an outer surface of the body portion 10 is provided with a second recess portion 15, the second recess portion 15 is extended along a circumferential direction of the body portion 10, wherein, the second recess portion 15 and the first recess portion 112 are disposed in a staggered manner.

In some embodiments, through disposing the second recess portion 15 on the outer surface of the body portion 10, wherein, the second recess portion 15 is extended along the circumferential direction of the body portion 10, and a wall surface of the second recess portion 15 is an arc-shaped surface or a wave-shaped surface integrally. Under an effect of the wire bodies 20, because of an existence of the second recess portion 15, the deformation of the body portion 10 is conveniently achieved.

In some embodiments, the second recess portion 15 and the first recess portion 112 are disposed in a staggered manner, namely along the axis direction of the body portion 10, the second recess portions 15 and the first recess portions 112 are successively disposed in a staggered manner, thus overall strength of the body portion 10 is also guaranteed under a precondition of guaranteeing the deformation.

In some embodiments, there are a plurality of second recess portions 15, and the plurality of second recess portions 15 are interval-configured along an axial direction of the body portion 10.

In some embodiments, the plurality of first recess portions 112 and the plurality of second recess portions 15 are successively disposed in a staggered manner along the axis direction of the body portion 10.

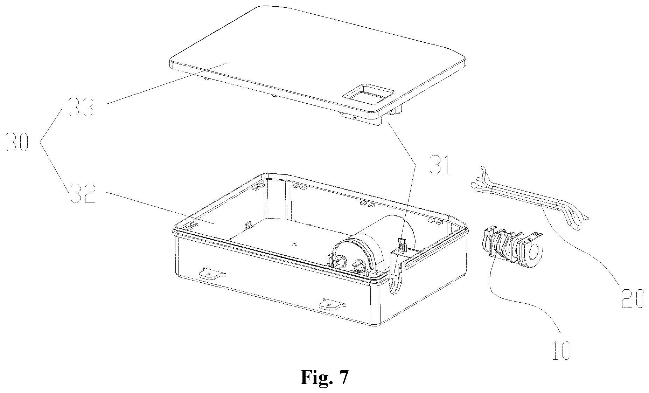

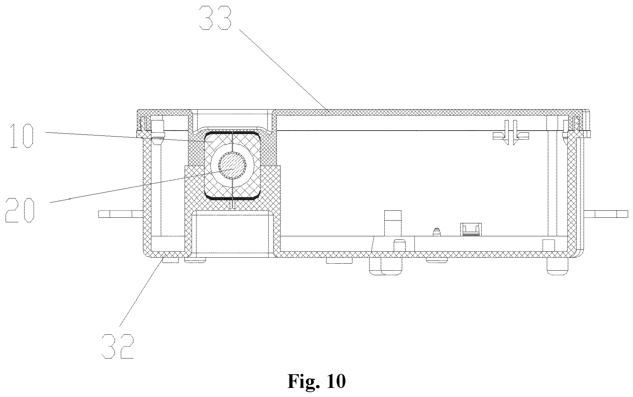

Some embodiments of the present invention further provides an electric box, reference to Fig. 7 to Fig. 10, the electric box includes a wire layout structure and an electric box body portion 30, the wire layout structure is the above wire layout structure, and the wire layout structure is disposed on the electric box body portion 30.

In order to enable the wire layout structure to be sealingly disposed on the electric box body portion 30, as shown in Fig. 7, the electric box body portion 30 is provided with an installing hole 31, at least a part of the body portion 10 of the wire layout structure is disposed in the installing hole 31, wherein, the body portion 10 is in interference fit with the installing hole 31.

In some embodiments, through disposing the installing hole 31 on the electric box body portion 30, at least a part of the body portion 10 of the wire layout structure is disposed in the installing hole 31, and the body portion 10 is in interference fit with the installing hole 31, thereby it is guaranteed that the body portion 10 is sealingly disposed with the electric box body portion 30, thus an outside substance is prevented from entering the interior of the electric box body portion 30.

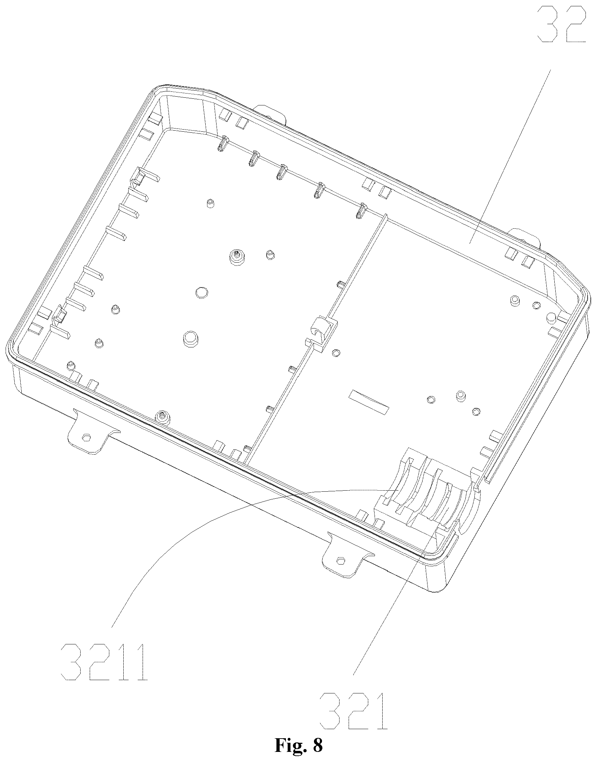

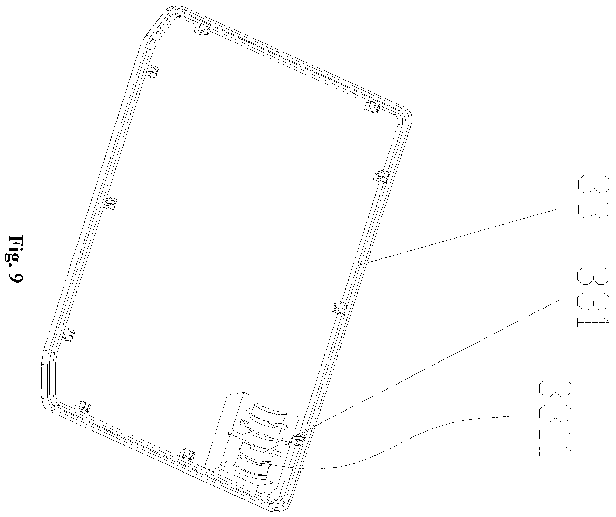

In allusion to a specific structure of the electric box body portion 30, as shown in Fig. 8 and Fig. 9, the electric box body portion 30 includes: a base 32, the base is provided with a first installing hole section 321; and a top cover 33, the top cover 33 is provided with a second installing hole section 331, the top cover 33 is connected with the base 32, the first installing hole section 321 is connected with the second installing hole section 331 in an opposite manner so as to form the installing hole 31, at least a part of the body portion 10 is clamped between the top cover 33 and the base 32.

In some embodiments, the electric box body portion 30 includes: the base 32 and the top cover 33, herein, the base 32 is provided with the first installing hole section 321, the top cover 33 is provided with the second installing hole section 331, in a process of specifically installing the body portion 10, the top cover 33 is separated from the base 32, after the body portion 10 is installed on the top cover 33 or the base 32, the top cover 33 is connected with the base 32, in this moment, the first installing hole section 321 is connected with the second installing hole section 331 in an opposite manner so as to form the installing hole 31, at least a part of the body portion 10 is clamped between the top cover 33 and the base 32, thus specific installing is achieved.

In some embodiments, the body portion 10 is in interference fit with an end face of the base 32, namely the body portion 10 is cooperated with the base 32 in a mode of protrusion or groove. Correspondingly, the body portion 10 is in interference fit with an end face of the top cover 33, namely the body portion 10 is cooperated with the top cover 33 in the mode of the protrusion or groove.

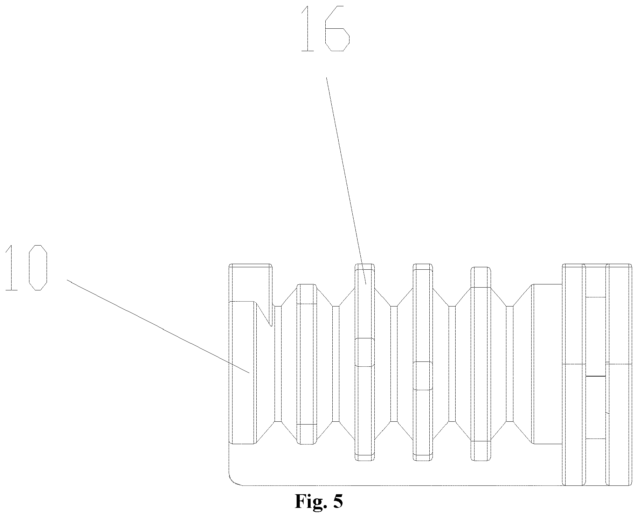

In order to guarantee that at least a part of the body portion 10 is stably clamped between the top cover 33 and the base 32, as shown in Fig. 5 and Fig. 8, the first installing hole section 321 is provided with a first installing groove 3211, the body portion 10 is provided with a first sealing protrusion 16, at least a part of the first sealing protrusion 16 is configured in the first installing groove 3211.

In some embodiments, through disposing the first installing groove 3211 on the first installing hole section 321, and disposing the first sealing protrusion 16 on the body portion 10, in a specific installing process, at least a part of the first sealing protrusion 16 is disposed in the first installing groove 3211, thus it is guaranteed that two parties are stably connected, and a sealing effect also is achieved.

Correspondingly, as shown in Fig. 9, the second installing hole section 331 is provided with a second installing groove 3311, the first installing groove 3211 is disposed opposite to the second installing groove 3311, the first sealing protrusion 16 is extended along a circumferential direction of the body portion 10, the first sealing protrusion 16 is configured between the first installing groove 3211 and the second installing groove 3311; and wherein, an outer surface of the first sealing protrusion 16 is in interference fit with at least a part of the groove bottom of the first installing groove 3211, and/or in interference fit with at least a part of the groove bottom of the second installing groove 3311.

In some embodiments, the outer surface of the first sealing protrusion 16 is in interference fit with the groove bottom of the first installing groove 3211 and/or at least a part of the groove bottom of the second installing groove 3311, thus it is guaranteed that along the circumferential direction of the first sealing protrusion 16, the first sealing protrusion 16 is in a sealing state.

In view of the sealing effect, there are a plurality of first sealing protrusions 16, the plurality of first sealing protrusions 16 are disposed along the axial direction of the body portion 10 in a spacing manner, there are a plurality of first installing grooves 3211 and a plurality of second installing grooves 3311, and the plurality of first installing grooves and the plurality of second installing grooves are disposed corresponding to the plurality of first sealing protrusions 16 in one-to-one correspondence manner.

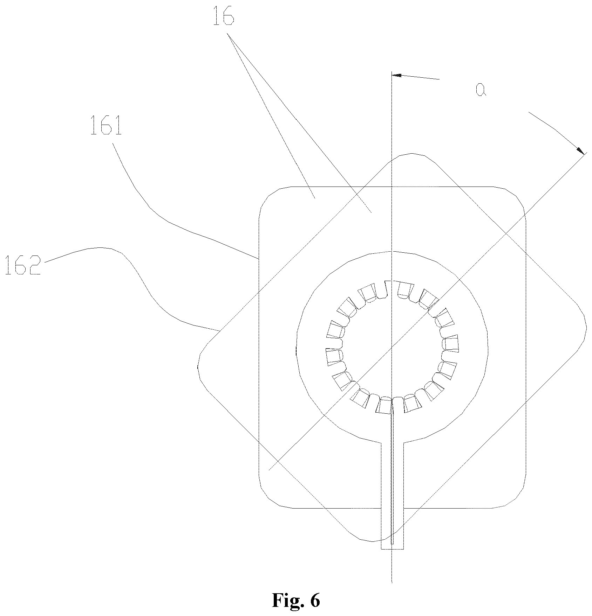

In allusion to specific structure and arrangement mode of the first sealing protrusions 16, as shown in Fig. 6, a projection, along the axial direction of the body portion 10, of the first sealing protrusion 16 is a polygon, wherein, at least two adjacent first sealing protrusions 16 are disposed in a staggered manner, an outer circumferential surface of the first sealing protrusion 16 is provided with a first faying surface 161, an outer circumferential surface of the second first sealing protrusion 16 is provided with a second faying surface 162, a preset included angle a is formed between the first faying surface 161 and the second faying surface 162, and the a is an acute angle.

In some embodiments, 0≤a≤75°.

In some embodiments, a=45°.

In some embodiments, there are a plurality of first sealing protrusions 16, the plurality of first sealing protrusions 16 are disposed along the axial direction of the body portion 10 in a spacing manner, and the projection, along the axial direction of the body portion 10, of the first sealing protrusion 16 is a polygon, namely an outer surface of the first sealing protrusion 16 forms a polygon.

In some embodiments, in order to guarantee a sealing effect, at least two adjacent first sealing protrusions 16 are disposed in a staggered manner, namely while two adjacent first sealing protrusions 16 are disposed, the two adjacent first sealing protrusions 16 are relatively rotated to a certain angle, so as to form a staggered mode. In some embodiments, the outer circumferential surface of the first sealing protrusion 16 is provided with the first faying surface 161, the outer circumferential surface of the second first sealing protrusion 16 is provided with the second faying surface 162, the preset included angle a is formed between the first faying surface 161 and the second faying surface 162, and the a is an acute angle.

In some embodiments, the projection, along the axial direction of the body portion 10, of the first sealing protrusion 16 is the polygon, a partial outer surface of the first sealing protrusion 16 is in interference fit with the groove bottom of the first installing groove 3211 in a staggered manner, and/or the groove bottom of the second installing groove 3311.

In some embodiments, outer surfaces of the plurality of first sealing protrusions 16 are in interference fit with the groove bottoms of the plurality of first installing grooves 3211 in a staggered manner, and/or in crossed interference fit with the groove bottoms of the plurality of second installing grooves 3311.

In some embodiments, the outer surfaces of the plurality of first sealing protrusions 16 are in interference fit with groove bottoms of the plurality of first installing grooves 3211 in a staggered manner, and in crossed interference fit with groove bottoms of the plurality of second installing grooves 3311 in a staggered manner, namely along circumferential directions of the plurality of first sealing protrusions 16, a closed sealing space is enclosed by a sealing surface of each first sealing protrusion 16, two adjacent sealing surfaces is intersected, or is just spliced.

In some embodiments, two opposite sides of the first sealing protrusion 16 are in interference fit with the first installing groove 3211 and the second installing groove 3311 at a same time.

In some embodiments, the projection, along the axial direction of the body portion 10, of the first sealing protrusion 16 is a quadrangle.

In some embodiments, there are 4 first sealing protrusions 16, the 4 first sealing protrusions 16 are interval-configured, wherein, disposing modes of the two first sealing protrusions 16 in a middle are a same, namely the configuration of rotating a certain angle does not exist between the two first sealing protrusions 16, correspondingly, the disposing modes of the two first sealing protrusions 16 in the outside are a same too.

In some embodiments, the wire 20 is a power wire.

The electric box of some embodiments in the present invention includes the base 32, an electric member, a wire layout rubber ring, the power wire and an electric box cover (top cover 33). Wherein, the electric box is fixed on an electric device through a mode of bolt fixing or fastener. The electric member is fixed on the base 32 through the mode of bolt fixing or fastener; and the power wire passes through the wire layout rubber ring and enters the electric box from the outside of the electric box. The wire layout rubber ring is cooperatively installed with the base 32 and the electric box cover through a clamping groove. The electric box cover is cooperatively installed with the base 32 through a mode of buckle or bolt.

In some embodiments, the wire layout rubber ring is oppositely opened and closed, the power wire is directly placed while the wire layout rubber ring is opened, after that, it is closed, thereby a purpose of fixing the power wire is achieved.

In some embodiments, the wire layout rubber ring is provided with a wave-shaped concave-convex surface (second recess portion 15 and first recess portion 112), a convex surface (a convex portion is formed between two adjacent first recess portions 112) is provided with cone-shaped colloidal particles (sealing portion 111).

In some embodiments, a middle of two sides of the wire layout rubber ring is provided with a thin-type connection sheet (connection section 14), conversion of opening and closing states is achieved.

In some embodiments, when the power wire is formed by a plurality of wires, a power wire matching gap exist between the plurality of wires of the power wire, at this moment, the cone-shaped colloidal particles on the wire layout rubber ring is inserted into the power wire matching gap, and the sealing is achieved.

At the same time, because the wire layout rubber ring is provided with a wave-shaped concave-convex surface, when a diameter size of the power wire is in a larger state, the wave-shaped concave-convex surface is deformed to stretch a rubber so as to adjust the diameter, and the sealing effect is achieved.

In order to achieve a sealing problem when the diameter of the power wire is less than an inner hole diameter of the wire layout rubber ring, a multi-clamping-position structure with a misalignment angle (cooperation relations of the first sealing protrusions 16 with the first installing groove 3211 and the second installing groove 3311) is designed between the wire layout rubber ring and the base 32 and the electric box cover. Two ends of a cooperation part of each buckle are in interference fit, through the interference fit, clamping grooves (first installing groove 3211 and second installing groove 3311) of the base 32 and the electric box cover extrude a clamping position (first sealing protrusion 16) of the wire layout rubber ring, such that sealing cooperation is achieved between a wave-shaped cone hole inside the wire layout rubber ring and the power wire. In a cooperation of the above clamping positions and clamping grooves, between two adjacent clamping positions and between two adjacent clamping grooves, there is a relation of 45 degrees of misalignment around an intermediate axis along a front and rear direction, further, there is also 45 degrees of a misalignment angel between the next clamping position and the previous clamping position.

Correspondingly, a number of the above-mentioned clamping positions and the misalignment angel between the clamping positions are adjusted according to a size difference or a structure difference of the electric box.

In some embodiments, a shape of the first sealing protrusion 16 is adapted to shapes of the first installing groove 3211 and the second installing groove 3311.

In some embodiments, through the above part design and cooperation scheme, a higher sealing degree between the wire layout rubber ring and the power wire is achieved, and a hidden dangers of fire and explosion is avoid by preventing a flammable refrigerant from entering the electric box through a wire inlet and outlet port of the electric box.

The wire layout structure of some embodiments in the present invention is a wire layout rubber ring, the electric box and the wire layout structure are capable of, through the multi-clamping-position structure with a misalignment angle (the cooperation relations of the first sealing protrusions 16 with the first installing groove 3211 and the second installing groove 3311), achieving complete sealing isolation between an inside and an outside of the electric box, and safety of an electric product is improved.

In some embodiments, installation of the power wire (wire body 20) is performed through a mode of oppositely opening and closing the wire layout rubber ring, so production efficiency is improved.

In some embodiments, through a structure (first clamping portion 122 and second clamping portion 132) with a self-clamping buckle, production efficiency of power wire installation is improved.

In some embodiments, the wire layout rubber ring is capable of achieving sealing of the wire inlet and outlet port of the power wire with the plurality of wires, preventing the flammable refrigerant from entering the electric box, and improving a safety of the electric product.

In some embodiments, the wire layout rubber ring is capable of achieving the sealing of the wire inlet and outlet port of the power wires with different wire diameters, preventing the flammable refrigerant from entering the electric box, and improving the safety of the electric product.

The electric box of the invention is good in sealability, and capable of achieving the sealing of the wire inlet and outlet port (an opening of the installing hole 31) of the electric box well. An assembly structure between the wire layout rubber ring and the electric box is simple, operability of production is strong, thereby the flammable refrigerant is safely configured in an air conditioning device, environmental social benefit is achieved and a safety accident is avoided, and loss of economic benefit is reduced.

Some embodiment of the present invention further provides an air conditioner, including an electric box, the electric box is the above electric box.

It is observed from the above description that the above embodiments of the present invention achieve the following technical effects.

The wire layout structure of the present invention is capable of, through rotatably configuring at least a part of the body portion 10, such that the accommodation hole 11 has the first state of releasing the wire bodies 20 and the second state of clamping the wire bodies 20, thereby improving installation efficiency of the wire bodies 20. Wh erein, the body portion 10 is provided with the accommodation hole 11 for accommodating the wire bodies 20. In the specific installing process, at least a part of the body portion 10 is rotated, such that the accommodation hole 11 is located in the first state, thereby the wire bodies 20 are placed in the accommodation hole 11, and then at least a part of the body portion 10 is rotated, such that the accommodation hole 11 is located in the second state, thus it is guaranteed that the wire bodies 20 are clamped by the body portion 10. The wire layout structure of the present invention is capable of, through rotatably configuring at least a part of the body portion 10, such that the accommodation hole 11 has the first state of releasing the wire bodies 20 and the second state of clamping the wire bodies 20, thereby improving the installation efficiency of the wire bodies 20, and solving the problem of low efficiency of installing the wire bodies in the wire layout structure in the are known to inventors.

It should be noted that the terms "first", "second", and the like in the specification and claims of the present invention and in the above drawings are configured to distinguish similar objects and are not necessarily configured to describe a specific sequence or order. It will be appreciated that the data configured in this way is interchanged where appropriate, so that the implementation manners of the present invention described herein can be implemented, for example, in an order other than those illustrated or described herein. In addition, the terms "include" and "have" and any variations thereof are intended to cover non-exclusive inclusions. For example, a process, method, system, product, or equipment that includes a series of steps or units need not be limited to those steps or units that are explicitly listed, and instead include other steps or units that are not explicitly listed or inherent to these processes, methods, products or equipment.

For ease of description, spatially relative terms such as "on", "over", "on an upper surface", "above", etc. are configured herein to describe a spatial position relationship between one device or feature as shown in the figures and other devices or features. It will be appreciated that the spatially relative terms are intended to comprise different orientations of the device in use or operation in addition to the orientation of the device described in the figures. For example, if the device in the figures is turned upside down, the device described as "over other devices or configurations" or "on other devices or configurations" will be positioned "below other devices or configurations" or "under other devices or configurations". Thus, the exemplary term "over" may include both "above" and "below". The device also is positioned in other different manners (rotated for 90 degrees or at other orientations), and the spatially relative descriptors configured herein are interpreted accordingly.

The foregoing descriptions are merely embodiments of the invention and are not intended to limit the invention. For those skilled in the art, the present invention has various changes and modifications. Any modifications, equivalent replacements and improvements made within the spirit and principle of the invention shall fall within the protection scope of the invention.

## Claims

1. A wire layout structure, comprising:
a body portion (10), the body portion (10) being provided with an accommodation hole (11) for accommodating a wire body (20),
wherein, at least a part of the body portion (10) is rotatably disposed, such that the accommodation hole (10) has a first state of releasing the wire body(20) and a second state of clamping the wire body (20).

2. The wire layout structure as claimed in claim 1, wherein the body portion (10) comprises:
a first body section (12); and
a second body section (13), wherein a first end of the first body section (12) is fixedly connected with a first end of the second body section (13), and a second end of the first body section (12) is detachably connected with a second end of the second body section (13),
wherein, at least one of the first body section (12) and the second body section (13) is provided with the accommodation hole (11), the first body section (12) is rotatably disposed relative to the second body section (13), such that the accommodation hole (11) has the first state and the second state.

3. The wire layout structure as claimed in claim 2, wherein the first body section (12) is provided with a first accommodating groove (121), and the second body section (13) is provided with a second accommodating groove (131), when the second end of the first body section (12) is connected with the second end of the second body section (13), the first accommodating groove (121) is connected with the second accommodating groove (131) in an opposite manner so as to form the accommodation hole (11).

4. The wire passage structure as claimed in claim 2, wherein the second end of the first body section (12) is in locked-connection with the second end of the second body section (13).

5. The wire layout structure as claimed in claim 4, wherein the first body section (12) is provided with a first clamping portion (122), the second body section (13) is provided with a second clamping portion (132), and the first clamping portion (122) is connected with the second clamping portion (132) in a clamping manner.

6. The wire layout structure as claimed in claim 5, wherein the first clamping portion (122) is a protrusion, the second clamping portion (132) is a groove, and the first clamping portion (122) is in interference fit with the second clamping portion (132); or the first clamping portion (122) is a groove, the second clamping portion (132) is a protrusion, and the first clamping portion (122) is in interference fit with the second clamping portion (132).

7. The wire layout structure as claimed in claim 2 or 3, wherein the body portion (10) further comprises:
a connection section (14), wherein the connection section (14) is disposed between the first end of the first body section (12) and the first end of the second body section (13), the connection section (14) is configured to connect the first body section (12) and the second body section (13),
wherein, the first body section (12) is rotatably disposed by taking the connection section (14) as a rotation shaft, and/or the second body section (13) is rotatably disposed by taking the connection section (14) as a rotation shaft.

8. The wire layout structure as claimed in claim 7, wherein the connection section (14) is a flexible structure.

9. The wire passage structure as claimed in claim 7, wherein the first body section (12), the second body section (13) and the connection section (14) are integrally formed.

10. The wire layout structure as claimed in claim 1, wherein a hole wall of the accommodation hole (11) is provided with a sealing portion (111), the accommodation hole (11) is configured to accommodate at least two wire bodies (20), and the sealing portion (111) is disposed between two adjacent wire bodies (20).

11. The wire layout structure as claimed in claim 10, wherein there are a plurality of sealing portions (111), the plurality of sealing portions (111) are disposed along a circumferential direction of the hole wall of the accommodation hole (11).

12. The wire passage structure as claimed in claim 10, wherein there are multiple rows of the sealing portions (111), the multiple rows of the sealing portions (111) are interval-configured along an axis direction of the accommodation hole (11), wherein, each row of the sealing portions (111) comprises multiple sealing sub-portions, and the multiple sealing sub-portions are interval-configured along the circumferential direction of the hole wall of the accommodation hole (11).

13. The wire layout structure as claimed in claim 1, wherein the body portion (10) is made of a flexible material, such that a size of the accommodation hole (11) is adjustably disposed.

14. The wire layout structure as claimed in claim 13, wherein the hole wall of the accommodation hole (11) is provided with a first recess portion (112), the first recess portion (112) is extended along a circumferential direction of the accommodation hole (11).

15. The wire layout structure as claimed in claim 14, wherein there are a plurality of first recess portions (112), and the plurality of first recess portions (112) are disposed along an axis direction of the accommodation hole (11).

16. The wire passage structure as claimed in claim 15, wherein a convex portion is formed between the two neighboring first recess portions (112), the convex portion is provided with the sealing portion (111), the accommodation hole (11) is used for accommodating at least two wires (20), and the sealing portion (111) is used to be configured between the two neighboring wires bodies (20).

17. The wire layout structure as claimed in claim 14, wherein an outer surface of the body portion (10) is provided with a second recess portion (15), the second recess portion (15) is extended along a circumferential direction of the body portion (10), wherein, the second recess portion (15) and the first recess portion (112) are disposed in a staggered manner.

18. The wire passage structure as claimed in claim 17, wherein there are multiple second recess portions (15), and the multiple second recess portions (15) are interval-configured along an axial direction of the body portion (10).

19. An electric box, comprising the wire layout structure as claimed in any one of claims 1 to 18 and an electric box body portion (30), wherein the wire layout structure is disposed on the electric box body portion (30).

20. The electric box as claimed in claim 19, wherein the electric box body portion (30) is provided with an installing hole (31), at least a part of the body portion (10) of the wire layout structure is disposed in the installing hole (31), wherein, the body portion (10) is in interference fit with the installing hole (31).

21. The electric box as claimed in claim 20, wherein the electric box body portion (30) comprises:
a base (32), wherein the base (32) is provided with a first installing hole section (321); and
a top cover (33), wherein the top cover (33) is provided with a second installing hole section (331), the top cover (33) is connected with the base (32), the first installing hole section (321) is connected with the second installing hole section (331) in an opposite manner, so as to form the installing hole (31), at least a part of the body portion (10) is disposed between the top cover (33) and the base (32) in a clamping manner.

22. The electric box as claimed in claim 21, wherein the first installing hole section (321) is provided with a first installing groove (3211), the body portion (10) is provided with a first sealing protrusion (16), at least a part of the first sealing protrusion (16) is disposed in the first installing groove (3211).

23. The electric box as claimed in claim 22, wherein the second installing hole section (331) is provided with a second installing groove (3311), the first installing groove (3211) is disposed opposite to the second installing groove (3311), the first sealing protrusion (16) is extended along a circumferential direction of the body portion (10), the first sealing protrusion (16) is disposed between the first installing groove (3211) and the second installing groove (3311); and wherein, an outer surface of the first sealing protrusion (16) is in interference fit with at least a part of a groove bottom of the first installing groove (3211) and/or in interference fit with at least a part of a groove bottom of the second installing groove (3311).

24. The electric box as claimed in claim 23, wherein there are plurality of first sealing protrusions (16), the plurality of first sealing protrusions (16) are disposed along an axial direction of the body portion (10) in a spacing manner, there are a plurality of first installing grooves (3211) and a plurality of second installing grooves (3311), and the plurality of first installing grooves and the plurality of second installing grooves are respectively disposed corresponding to the plurality of first sealing protrusions (16) in one-to-one correspondence manner.

25. The electric box as claimed in claim 24, wherein a projection, along the axial direction of the body portion (10), of the first sealing protrusion (16) is a polygon, wherein, at least two adjacent first sealing protrusions (16) are disposed in a staggered manner, an outer circumferential surface of the first sealing protrusion (16) is provided with a first faying surface (161), an outer circumferential surface of the second first sealing protrusion (16) is provided with a second faying surface (162), a preset included angle a is formed between the first faying surface (161) and the second faying surface (162), and the a is an acute angle.

26. The electric box as claimed in claim 24 or 25, wherein the projection, along the axial direction of the body portion (10), of the first sealing bulge (16) is the polygon, a partial outer surface of the first sealing bulge (16) is in interference fit with the groove bottom of the first installing groove (3211), and/or the groove bottom of the second installing groove (3311).

27. The electric box as claimed in claim 26, wherein outer surfaces of the multiple first sealing bulges (16) are in crossed interference fit with the groove bottoms of the multiple first installing grooves (3211), and/or in crossed interference fit with the groove bottoms of the multiple second installing grooves (3311).

28. An air conditioner, comprising the electric box as claimed in any one of claims 19 to 27.
